# EUROPEAN PATENT APPLICATION

(11) **EP 1 122 607 A1**
(43) Date of publication of application: **08.08.2001**
(21) Application number: 01301009.5
(22) Date of filing: 05.02.2001
(51) Int. Cl.: G03F 7/039

(54) **High resolution photoresist compositions**

(30) Priority: 07.02.2000 US 180905 P
(71) Applicant: Shipley Company LLC, Marlborough, MA 01752 (US)
(72) Inventor: Barclay, George G., Jefferson, Massachusetts 01522 (US); Heumann, Roberg G., Mendon, Massachusetts 01756 (US); Rutter, Edward W., Jr., Franklin, Massachusetts (US); Chen, Jung-Kuang R., Poughkeepsie, New York 12603 (US); Lawson, Margaret C., LaGrangeville, New York 12540 (US); Jordhamo, George M., Hopewell Junction, New York 12533 (US); Hughes, Tiomothy M., Marlboro, New York 12542 (US); Moreau, Wayne M., Wappingers Falls, New York 12590 (US); Mewherter, Ann Marie, Wappingers Falls, New York 12590 (US)
(74) Representative: Buckley, Guy Julian

(57) **Abstract**

The invention provides photoresists and resist preparative methods. Methods of the invention include treatment of a resist resin with methylene chloride or other organic solvent to remove low molecular weight materials. It has been found that the treated resin can be formulated into resists that provide manufactured electronic devices with significantly reduced defects.

## Description

### BACKGROUND OF THE INVENTION

### 1. Field of the Invention

The present invention relates to photoresist compositions and methods for preparation of same and, more particularly, to preparative methods that produce high resolution resists.

### 2. Background

Photoresists are photosensitive films for transfer of images to a substrate and form negative or positive images. After coating a photoresist on a substrate, the coating is exposed through a patterned photomask to a source of activating energy such as ultraviolet light to form a latent image in the photoresist coating. The photomask has areas opaque and transparent to activating radiation that define a desired image to be transferred to the underlying substrate. A relief image is provided by development of the latent image pattern in the resist coating. The use of photoresists is generally described, for example, by Deforest, Photoresist Materials and Processes, McGraw Hill Book Company, New York (1975), and by Moreau, Semiconductor Lithography, Principals, Practices and Materials, Plenum Press, New York (1988).

While currently available photoresists are suitable for many applications, current resists also can exhibit significant shortcomings, particularly in high performance applications such as e.g. formation of highly resolved sub-half micron and sub-quarter micron features.

More recently, chemically-amplified-type resists have been increasingly employed. Such photoresists may be negative-acting or positive-acting and generally include many crosslinking events (in the case of a negative-acting resist) or deprotection reactions (in the case of a positive-acting resist) per unit of photogenerated acid. In the case of positive chemically-amplified resists, certain cationic photoinitiators have been used to induce cleavage of certain "blocking" groups pendant from a photoresist binder, or cleavage of certain groups that comprise a photoresist binder backbone. See, for example, U.S. Patents Nos. 5,075,199; 4,968,581; 4,883,740; 4,810,613; and 4,491,628, and Canadian Patent Application 2,001,384 Upon cleavage of the blocking group through exposure of a coating layer of such a resist, a polar functional group is formed, e.g., carboxyl or imide, which results in different solubility characteristics in exposed and unexposed areas of the resist coating layer. See also R.D. Allen et al., Proceedings of SPIE, 2724:334-343 (1996); and P. Trefonas et al. Proceedings of the 11th International Conference on Photopolymers (Soc. Of Plastics Engineers), pp 44-58 (Oct. 6, 1997).

It would be desirable to have new photoresist compositions, including resist compositions that can produce highly resolved images. It also would be desirable to have methods for preparation of such photoresist compositions.

### SUMMARY OF THE INVENTION

We have now discovered new photoresist compositions that can provide manufactured microelectronic devices that have reduced defects, including devices that are substantially, essentially or even completely free of defects. We also have discovered new methods to prepare such photoresists.

More specifically, in a preferred aspect, methods are provided that remove undesired portions of the resist resin components. Removal of those components surprisingly has provided photoresist compositions that provide processed microelectronic wafers and other defects that exhibit reduced defects, relative to wafers produced with comparable resists where the undesired resin components have not been removed.

In preferred methods of the invention, resist resins are washed or otherwise treated with one or more organic solvents. Methylene chloride is particularly preferred. That solvent treatment has been found (e.g., GPC analysis) to remove relatively low molecular weight monomeric, oligomeric or polymeric species. Preferably, such treatment removes resin species having a molecular weight of about 2,000 daltons or less, more preferably of about 1000 daltons or less, still more preferably of about 800 daltons or less, even more preferably of about 500 daltons or less.

The thus treated resin component can be formulated with other resist components such as a photoacid generator and the resulting resist composition coated, exposed to patterned activating radiation and developed to provide a resist relief image on a microelectronic wafer or other substrate surface.

As noted above, the resin is preferably washed or otherwise treated with an organic solvent. Preferred methods of treating the resin component also may comprise isolating the resin using a suitable filter, optionally followed by one or more washing steps. Additionally, the resin may be treated using extraction methods, e.g., soxhlet extraction, with an organic solvent, in particular methylene chloride, chloroform, anisole and the like

It also has been found that solvent treatment results in reduced, or even complete elimination, of defects on the processed microelectronic wafer or other substrate.

Preferably, the resin will be a phenolic polymer, e.g. a novolak, poly(vinylphenol) or a phenolic copolymer such as a phenoliclacrylate copolymer. Unless otherwise indicated, references herein to copolymer include bipolymer (two distinct polymers), as well as higher order polymers such as terpolymers, tetrapolymers and the like. In general, deblocking resins are preferred that are employed in positive-acting chemically amplified resists. For example, preferred are polymers that contain photoacid-labile ester or acetal/ketal groups.

Polymers treated in accordance with the invention may have a variety of other units, e.g. cyano units such as may be provided by polymerization of acrylonitrile or methyl acrylonitrile; styrene and substituted styrene units; alicyclic units such as may be provided by polymerization of cyclic olefins e.g. vinyl isobornyl, etc.; carboxylic acid units; anhydride units such as itaconic anhydride units; and the like.

The invention also provides methods for forming relief images, including methods for forming a highly resolved relief image such as a pattern of lines where each line has essentially vertical sidewalls and a line width of about 0.40 microns or less, and even a width of about 0,25, 0.20 or 0.16 microns or less. The invention further provides articles of manufacture comprising substrates such as a microelectronic wafer substrate or liquid crystal display or other flat panel display substrate having coated thereon a polymer, photoresist or resist relief image of the invention. Other aspects of the invention are disclosed infra.

### DETAILED DESCRIPTION OF THE INVENTION

As discussed above, we have discovered that organic solvent treatment of a resist resin component can provide significantly enhanced quality microelectronic devices. In particular, the organic solvent treatment provides manufactured products of reduced defects. Preferred methods of the invention include treating a prepared (i.e. polymer already synthesized in the form to be used in a resist composition) with one or more organic solvents. The thus treated resin then can be admixed with a photoactive component to provide a photoresist composition. Typically, the resin being treated with the one or more organic solvents will have been isolated from a resin synthesis mixture prior to treatment with the organic solvent(s).

The organic solvent treatment of the resist resin can be conducted by any of a variety of methods. For instance, the polymer can be dissolved or more typically dispersed (e.g., slurry process) in an organic solvent such as methylene chloride for a period of time.

Preferably, the resin/solvent mixture is stirred or otherwise agitated for an extended period, e.g. at least about 15 to 30 minutes, more preferably at least 1, 2, 3, 4, 5, 6, 7, 8, 9, or 10 hours. After such treatment, the resin can be isolated, e.g, by removal of the solvent under reduced pressure, or simple filtering of the resin if it is not dissolved in the solvent. The treated polymer is preferably dried such as in a vacuum oven prior to formulation into a resist composition. See Example 1 which follows, for exemplary treatment conditions. A polymer also can be treated in accordance with the invention simply by washing on a filter, although the more extended treatment times as exemplified in Example 1 below are generally more preferred. A polymer also can be extracted with a solvent or solvent mixture.

A polymer also can be subjected to repeated organic solvent treatments in accordance with the invention, preferably with isolation of the polymer between each treatment. For instance, a polymer can be slurried in one or more organic solvents, isolated from the organic solvent, and reslurried in one or more organic solvents, isolated again, and then either formulated into a resist composition, or even treated again with an organic solvent. Generally, a polymer will be treated 1, 2, 3, 4 or 5 times separately with one or more organic solvents prior to formulation into a resist composition. It has been found that multiple organic solvent treatments can provide reduced defects in devices processed with the polymer. See, for instance, the results set forth in Table 4 of Example 3, which follows.

Preferably, the organic solvent or solvent mixture will provide a partitioning of the lower molecular weight monemeric, oligomeric or polymeric species from the higher molecular weight polymers of the polymer being treated in accordance with the invention.

Preferably, organic solvent treatment methods of the invention result in the treated polymer having about 1 weight percent or less of material with a Mw of 2,000 or less as determined by GPC-UV analysis, more preferably the treatment methods of the invention result in the treated polymer having about 0.75 or 0.5 weight percent or less of material with a Mw of 2,000 or less, as determined by GPC-UV analysis.

Typically, the organic solvent treatment methods of the invention will result in an increase of the Tg of the treated polymer, e.g. a Tg increase of at least about 5oC or 10oC relative to the same, untreated polymer.

Generally preferred for use in the methods of the invention are organic solvents that can provide sufficient partitioning (solubility differentials) between lower molecular weight species (e.g. Mw of 2,000 or 1,100 daltons or less) and higher molecular weight species of a polymer sample. In addition to methylene chloride, other halogenated solvents will be suitable such as chloroform, or solvents with other polar groups such as an ester, e.g. ethyl acetate. Solvents having a boiling point below about 120°C, 100°C or 85°C are generally preferred to facilitate solvent removal and drying of the treated polymer. Other suitable treatment solvents include a lactate such as methyl lactate or ethyl lactate, and other hydroxyl solvents such a glycol; ethers such as anisole; relatively non-polar solvents such as an alkane, e.g. n-hexane, cyclohexane, heptane, or petroleum ether; alcohols such as methanol or ethanol; and the like. Solvent mixtures also will be suitable and the mixture components can be adjusted to provide optimal solubility differentials of lower and higher molecular species of a polymer sample being treated, as generally discussed above. For instance, a mixture of two or more solvents can be employed, e.g. where the solvents differ in polarity, such as a mixture of methanol/heptane and the like.

In preferred aspects, the resin treated with an organic solvent is a phenolic resin, including phenolic resins that contain phenolic OH sites bonded to another moiety such as acid labile groups e.g. those groups disclosed in U.S. Patent 5,258,257 to Sinta et al., or inert blocking groups as described in U.S. Patent 5,514,520 to Thackeray et al.

Preferred phenolic resins that can be employed treated in accordance with the invention include novolak and poly(vinylphenol) resins. Preparation of such phenolic resins is known. Examples of suitable phenols for condensation with an aldehyde, especially formaldehyde, for the formation of novolak resins include phenol; m-cresol; o-cresol; p-cresol; 2,4-xylenol; 2,5-xylenol; 3,4-xylenol; 3,5-xylenol; thymol and mixtures thereof. An acid catalyzed condensation reaction results in formation of a suitable novolak resin which may vary in molecular weight from about 500 to 100,000 daltons. Poly(vinylphenols) may be prepared, e.g., as disclosed in U.S. Patent No. 4,439,516. Preferred resins and the preparation thereof are also disclosed in U.S. Patent No. 5,128,230.

Poly(vinylphenols) may be formed by block polymerization, emulsion polymerization or solution polymerization of the corresponding monomers in the presence of a catalyst. Vinylphenols useful for the production of polyvinyl phenol resins may be prepared, for example, by hydrolysis of commercially available coumarin or substituted coumarin, followed by decarboxylation of the resulting hydroxy cinnamic acids. Useful vinylphenols may also be prepared by dehydration of the corresponding hydroxy alkyl phenols or by decarboxylation of hydroxy cinnamic acids resulting from the reaction of substituted or nonsubstituted hydroxybenzaldehydes with malonic acid. Preferred polyvinylphenol resins prepared from such vinylphenols have a molecular weight range of from about 2,000 to about 60,000 daltons.

Copolymers containing phenol and nonaromatic cyclic alcohol units also are preferred resins treated in accordance with the invention and may be suitably prepared by partial hydrogenation of a novolak or poly(vinylphenol) resin. Such copolymers and the use thereof in photoresist compositions are disclosed in U.S. Patent No. 5,128,232 to Thackeray et al.

Further preferred resins treated in accordance with the invention include those resins formed from bishydroxymethylated compounds, and block novolak resins. See U.S. Patents Nos. 5,130,410 and 5,128,230 where such resins and use of same in photoresist compositions are disclosed.

Acetate groups are preferred acid labile groups to functionalize phenolic OH moieties of a phenolic resin. To provide such groups, a phenolic resin binder precursor may be condensed with a suitable addition compound such as a compound of the formula L-CR¹R²C(=O)-O-R³, where L is a leaving group such as bromide or chloride, R¹ and R² are each independently hydrogen, an electron withdrawing group such as halogen (particularly F, Cl or Br), or substituted or unsubstituted C₁₋₁₀ alkyl; and R³ is substituted or unsubstituted C₁₋₁₀ alkyl, or substituted or unsubstituted aryl such as phenyl or aryalkyl such as benzyl. Condensation of such addition compound provides the groups of the formula -R¹R²C(=O)-O-R³ pendant to the resin binder backbone and grafted onto the resin's available hydroxyl groups. Photoacid degradation of those groups during exposure and/or post-exposure heating provides the polar acetic acid ether moiety pendant to the resin binder backbone. Other preferred acid labile groups pendant to a resin binder backbone include oxycarbonyl groups such as those of the formula -C(=O)OR³ where R³ is as defined above and preferably is t-butyl or benzyl. Such groups are provided by reaction of a resin binder precursor with a suitable addition compound such as a di-alkyl-dicarbonate, e.g. di-t-butyl-dicarbonate. See U.S. Patent 5,258,257 to Sinta et al. and other documents cited therein for discussions of acid labile groups.

Preferred inert blocking groups to functionalize phenolic OH moieties of phenolic resin binder precursors are disclosed in U.S. Patent 5,514,520 to Thackeray et al. As specified in that patent, and referred to herein, an inert blocking group is a group pendant to a resin and that is chemically unreactive in the presence of acid or base generated during exposure and baking of the photoresist composition. Preferred inert blocking groups grafted onto available hydroxyl groups of a resin binder include alkyl (to provide -O-alkyl pendant groups) such as methyl, ethyl, propyl, n-butyl, sec-butyl, t-butyl, etc.; alkanoyl group (to provide RCOO- pendant groups where R is preferably C₁₋₄ alkyl); a sulfonyl acid ester such as methanesulfonyl, ethanesulfonyl, propanesulfonyl, benzensulfonyl, toluenesulfonylesters, etc. Such groups may be grafted onto a suitable resin binder precursor such as a phenolic resin by an alkaline or acidic condensation reaction with a suitable addition compound, e.g. reaction of a sulfonic acid halide or other compound with suitable leaving group with a phenolic polymer in the presence of a suitable catalyst such as sodium hydroxide in the case of an alkaline condensation. See also the procedures disclosed in U.S. Patent 5,514,520.

Preferably, the organic solvent treatment is conducted after such acid labile or inert blocking groups are grafted onto or otherwise formed on a phenolic or other base resin.

Thereafter, the treated resin is formulated with other components to provide a photoresist composition. More particularly, the treated resin is admixed with a photoactive component, typically a photoacid generator compound, and solvent to provide a liquid photoresist formulation.

Preferably a photoacid generator or other photoactive compound will be present in a resist composition in an amount sufficient to generate a latent image in a coating layer. A variety of photoacid generators may be employed. For example, sulfonate compounds are preferred PAGs, particularly sulfonate salts. Two specifically preferred agents are of the following structures 1 and 2:

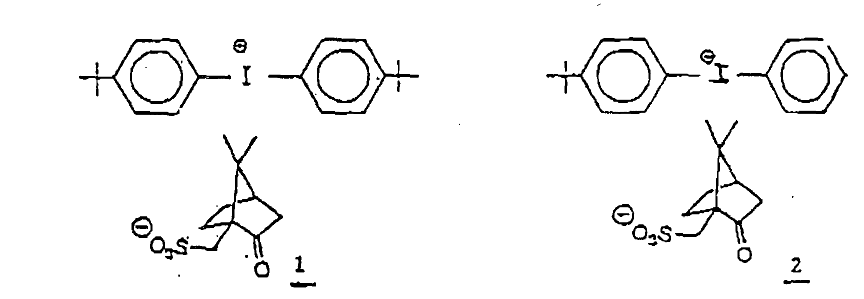

Such sulfonate compounds can be prepared as disclosed in European Patent Application 96118111.2 (publication number 0783136).

Suitable sulfonated esters also have been reported in J. of Photopolymer Science and Technology, vol. 4, No. 3,337-340 (1991), incorporated herein by reference, including benzoin tosylate, t-butylphenyl alpha-(p-toluenesulfonyloxy)-acetate and t-butyl alpha-(p-toluenesulfonyloxy)-acetate. Preferred sulfonate PAGs are also disclosed in U.S. Patent 5,344,742 to Sinta et al.

Onium salts are preferred acid generators for resists prepared in accordance with the invention. Onium salts that weakly nucleophilic anions have been found to be particularly suitable. Examples of such anions are the halogen complex anions of divalent to heptavalent metals or non-metals, for example, Sb, Sn, Fe, Bi, Al, Ga, In, Ti, Zr, Sc, D, Cr, Hf, and Cu as well as B, P, and As. Examples of suitable onium salts are diaryl-diazonium salts and onium salts of group Va and B, Ia and B and I of the Periodic Table, for example, halonium salts, quaternary ammonium, phosphonium and arsonium salts, aromatic sulfonium salts and sulfoxonium salts or selenium salts. Examples of suitable preferred onium salts can be found in U.S. Patents 4,442,197; 4,603,101; and 4,624,912.

Other useful acid generators include the family of nitrobenzyl esters, and the s-triazine derivatives. Suitable s-triazine acid generators are disclosed, for example, in U.S. Patent 4,189,323. Non-ionic photoacid generators are suitable including halogenated non-ionic, photoacid generating compounds such as, for example, 1,1-bis(p-chlorophenyl)-2,2,2-trichloroethane (DDT); 1,1-bis(p-methoxyphenol)-2,2,2-trichloroethane; 1,1-bis(chlorophenyl)-2,2,2 trichloroethanol; tris(1,2,3-methanesulfonyl)benzene; and tris(trichloromethyl)triazine. Suitable photoacid generators are also disclosed in European Patent Application Nos. 0164248 and 0232972.

Photoresists prepared in accordance with the invention may contain other components, e.g., a dye compound. Other optional photoresist materials include anti-striation agents, plasticizers, speed enhancers, etc. Such optional additives typically will be present in minor concentration in a photoresist composition except for fillers and dyes which may be present in relatively large concentrations such as, e.g., in amounts of from about 5 to 30 percent by weight of the total weight of a resist's dry components.

The resist compositions of the invention can be readily prepared by those skilled in the an. As discussed above, a photoactive component can be added to treated resin to provide a positive-acting resist. Negative-acting resists would typically include adding of a crosslinking compound to the resin component in addition to a photoactive component. Typically, the solids content of a resist composition varies between about 5 and 35 percent by weight of the total weight of the photoresist composition. The resin binder and PAG components should be present in amounts sufficient to provide a film coating layer and formation of good quality latent and relief images.

If desired, the resist composition may be filtered prior to use, or a solution of the resist resin binder may be filtered prior to addition of the photoactive component or other additives during formulation of the resist.

Photoresist compositions prepared in accordance with the invention can be used in accordance with generally known procedures. Thus, for example, a liquid coating composition of the invention is applied to a substrate such as by spinning, dipping, roller coating or other conventional coating technique, When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon or silicon dioxide wafers for the production of microprocessors and other integrated circuit components. Aluminum-aluminum oxide, gallium arsenide, ceramic, quartz or copper substrates also may be employed. Substrates used for liquid crystal display and other flat panel display applications are also suitably employed, e.g. glass substrates, indium tin oxide coated substrates and the like.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, an activating exposure wavelength is employed and the exposure energy typically ranges from about 10 to 300 mJ/cm2, dependent upon the exposure tool and the components of the photoresist composition.

Following exposure, a film layer of a resist composition can be baked e.g. at temperatures ranging from about 70°C to about 160°C. Thereafter, the film is developed, typically with an alkaline aqueous based developer such as a tetra-alkyl ammonium hydroxide aqueous solution. Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a plasma gas etch (e.g an oxygen plasma etch) and a hydrofluoric acid etching solution. After such processing, resist may be removed from the processed substrate using known stripping procedures.

All documents mentioned herein are incorporated herein in their entirety by reference,

The following non-limiting examples are illustrative of the invention.

### Example 1

A polymer was treated in accordance with the invention as follows. 600g of a terpolymer having 60 mole percent of para-hydroxystyrene units, 20 mole percent of styrene units and 20 mole percent t-butylacrylate units was added to a stirring solution of dichloromethane (6000 ml) in a 10 L beaker equipped with a large magnetic stir bar. After addition of the terpolymer the beaker was covered with aluminum foil, to avoid excess evaporation of the dichloromethane. The polymer slurry was then stirred for 3 hours. After 3 hours the polymer was filtered from the dichloromethane, using a Buchner funnel. The filter cake was then washed with 1000 ml of dichloromethane, and "sucked" as dry as possible on the Buchner funnel. The polymer was then transferred to a drying tray, which was covered in aluminum foil and placed in a vacuum oven overnight at 50°C. This resulted in a yield of 550g of the treated terpolymer (the treated terpolymer referred to below as the "washed polymer").

The dichloromethane filtrate was saved and evaporated down using a rotary evaporator (that isolated filtrate material referred to below as the "extract material").

The washed polymer; a sample of the same 60:20:20 para-hydroxystyrene:styrene:t-butylacrylate terpolymer that had not been washed or otherwise treated with methylene chloride (referred to below as the "initial polymer"); and the extract material were each analyzed by Gel-permeation chromatography with ultraviolet detector (GPC-UV) to determine the amount of low Mw material in the each of the polymers and the extract material. Further, the washed and unwashed polymers were also characterized by thermal gravimetric analysis (TGA) to determine the amount of residuals in the polymers. Table 1 shows the amount of low Mw material/residuals determined by GPC-UV and TGA techniques.

**Table 1**

| Analysis Points: | GPC-UV | TGA |
|---|---|---|
| 1) Initial Polymer | 2.6 wt. % | 4.2% |
| 2) Washed Polymer | 0.5 wt. % | 0.0 wt. % |
| 3) Filtrate | 61.0 wt.% | ----- |

NMR spectroscopy, IR spectroscopy and UV spectrophotometery also were used to identify the components of the extract material. The extract was found to contain 4-ethylphenol, styrene, mineral spirits and other aromatic and aliphatic impurities. Analysis showed the extracted material to be composed of materials having an Mw of approximately 2000 Dalton and below, demonstrated that aliphatic and aromatic oligomers are present in the unwashed, initial polymer and that these materials can be reduced by washing the polymer in methylene chloride.

The washed polymer and unwashed, initial polymer thermal characteristics were also characterized by differential scanning calorimetry (DSC) to determine the glass transitions (Tg) of the materials. The DSC analysis showed that the unwashed polymer gave a Tg of 131°C while the washed material had a significantly higher Tg of 146oC.

### Example 2

Photoresists of the invention were prepared and processed as follows.

The washed polymer and unwashed, initial polymer as described in Example 1 where then used to make two identical photoresist formulations consisting of the components in the following Table 2. The photoresist containing the washed polymer of Example I is referred to below as Resist 1, and the photoresist containing the unwashed polymer of Example 2 is referred to below as Resist 2. A third photoresist (referred to below as "Resist 3") was prepared that contained the components specified in the following Table 1, and the polymer was the same same 60:20:20 para-hydroxystyrene:styrene:t-butylacrylate terpolymer described in Example, but which had been Soxhlet extracted with methylene chloride and dried prior to resist formulation.

**Table 2**

| Component | Wt% of solution |
|---|---|
| Polymer (washed; unwashed, initial; or Soxhlet extracted) | 12.91% |
| PAG 1 | 0.581% |
| PAG 2 | 0.064% |
| TBAL | 0.045% |
| SLA | 0.068% |
| Solvent 1 | 60.448% |
| Solvent 2 | 25.880% |

In Table 2, PAG 1 is the photoacid generator di-(t-butylphenyl)iodoninm camphor sulfonate (structure 1 above), PAG 2 is the photoacid generator di-(t-butylphenyl)iodonium trifluoromethyl benzyl sulfonate; TBAL is tetrabutylammonium lactate; SLA is the surface leveling agent of Silwet L-7604; Solvent 1 is ethyl lactate; and Solvent 2 is ethyl ethoxy propionate.

Resists 1 and 2 were both filtered through 0.2 micron PTFE filters into clean glass bottles. Both Resists 1 and 2 were then spin coated onto an 8" silicon wafers and exposed through a chrome on glass reticule with a ASML DUV stepper and processed identically as follows. Each of Resists 1 and 2 were coated onto silicon wafers over a bottom organic, antireflective composition layer (600 angstrom antireflective layer). The coated Resists 1 and 2 were both soft-baked at 130°C for 60 seconds to provide resist film thickness layers of 4500 angstroms. The soft-baked layers of Resists 1 and 2 were then each exposed to patterned 248 nm radiation with ASML DUV Stepper (63NA, 0.814 outer, 0,57 inner), and developed with an aqueous alkaline developer solution (single puddle for 30 seconds).

The wafers with resist relief images thereon were then inspected for defects using an automated KLA 8100 CD measurement tool and all defects flagged by the tool were subsequently inspected, for confirmation. The results of this defect data showed that wafers having thereon Resists 1 and 3 formulated with the methylene chloride treated polymers had significantly less post process defects than the wafers having thereon Resist 2 formulated the unwashed, initial polymer. Table 3 shows the results of the post process defect analysis.

**Table 3**

| Sample and Treatment thereof | Defects |
|---|---|
| Resist 2 (unwashed, initial polymer) | 350+50 |
| Resist 1 (washed polymer) | 108+36 |
| Resist 2 (Soxhlet extracted polymer) | 71+36 |

### Example 3

600g of 60/20/20 terpolymer that consisted of 60 mole percent 4-hydroxystyrene units, 20 mole percent of styrene units and 20 mole percent of t-butylacrylate units, was added to a stirring solution of anisole (6000 ml) in a 10 L beaker equipped with a large magnetic stir bar. After addition of the terpolymer the beaker was covered. The polymer slurry was then stirred for 3 hours. After 3 hours the polymer was filtered from the anisole, using a Buchner funnel. The filter cake was then washed with 1000 ml of anisole, and "sucked" as dry as possible on the Buchner funnel. The polymer was then transferred to a drying tray, which was covered in aluminum foil and placed in a vacuum oven overnight at 50°C. This resulted in a yield of 535g of purified terpolymer.

In addition such anisole treatment, a sample of the 60/20/20 4-hydroxystyrene:styrene:t-butylacrylate terpolymer was washed three times separately with methylene chloride as described for the anisole treatment immediately above.

Set forth in Table 4 below are defect testing results using the terpolymer treated with anisole (indicated as Washed, Anisole in Table 4) and the terpolymer treated with methylene chloride (indicated as 1^{st} Wash, 2^{nd} Wash, 3^{rd} Wash in Table 4 below) as described immediately above, relative to the same terpolymer that had not been treated with an organic solvent (indicated as Unwashed, none in Table 4).

The defect testing was conducted as described in Example 2 above. Briefly, the tested polymers were formulated into photoresist compositions by admixing with the same and amounts thereof of resist solvent and a photoacid generator compound. The thus prepared resist compositions were then processed identically, specifically spin coated onto silicon wafers, soft-baked to remove solvent, exposed to patterned activating radiation, and developed with an aqueous alkaline developer to provide relief images. The wafers with resist relief images were then inspected for defects using an automated KLA 8100 CD measurement tool. Table 4 shows the results of the post process defect analysis.

**Table 4**

| Treatment | Solvent | Number of Defects |
|---|---|---|
| Unwashed | none | 305 |
| Washed | Anisole | 77 |
| 1st Wash | Dichloromethane | 108 |
| 2nd Wash | Dichloromethane | 68 |
| 3rd Wash | Dichloromethane | 29 |

### Example 4

500g off a copolymer that consisted of 80 mole percent of poly(4-hydroxysryrene and 20 mole percent of 2-methyladamantane methacrylate was added to a stirring solution of dichloromethane (5000 ml) in a 10 L beaker equipped with a large magnetic stir bar. After addition of the copolymer the beaker was covered. The polymer slurry was then stirred for 3 hours. After 3 hours the polymer was filtered from the dichloromethane, using a Buchner funnel. The filter cake was then washed with 1000 ml of dichloromethane, and "sucked" as dry as possible on the Buchner funnel. The polymer was then transferred to a drying tray, which was covered in aluminum foil and placed in a vacuum oven overnight at 50°C. This resulted in a yield of 480g of purified poly(4-hydroxystyrene-co-2-methyladamantane methacrylate). Set forth in Table 5 below are defect testing results using this poly(4-hydroxystyrene-co-2-methyladamantane methacrylate) co-polymer treated in such manner with methylene chloride (referred to as "Washed" treatment in Table 5), relative to the same copolymer that had not been treated with an organic solvent (referred to as "Unwashed" treatment in Table 5).

The defect testing was conducted as described in Example 2 above. Briefly, the tested polymers were formulated into photoresist compositions by admixing with the same and amounts thereof of resist solvent and a photoacid generator compound. The thus prepared resist compositions were then processed identically, specifically spin coated onto silicon wafers, soft-baked to remove solvent, exposed to patterned activating radiation, and developed with an aqueous alkaline developer to provide relief images. The wafers with resist relief images were then inspected for defects using an automated KLA 8100 CD measurement tool. Table 5 shows the results of the post process defect analysis.

**Table 5**

| Treatment | Solvent | Number of Defects |
|---|---|---|
| Unwashed | none | 56 |
| Washed | dichloromethane | 39 |

The foregoing description of the invention is merely illustrative thereof, and it is understood that variations and modifications can be effected without departing from the spirit or scope of the invention as set forth in the following claims.

## Claims

1. A method for preparation of a photoresist composition comprising:
(a) treating a prepared resin with one or more organic solvents; and
(b) admixing the treated resin with a photoactive component to provide a photoresist composition.

2. The method of claim 1 wherein the resin has been isolated from a resin synthesis mixture prior to treatment with the one or more organic solvents.

3. The method of claim 1 wherein the treatment with one or more organic solvents separates low molecular weight species of the resin from higher molecular weight species of the polymer.

4. The method of claim 1 wherein treatment with the one or more organic solvents removes resin species having a Mw of about 2,000 or less.

5. The method of claim 1 wherein treatment with the one or more organic solvents removes resin species having a Mw of about 100 or less.

6. The method of claim I wherein treatment with the one or more organic solvents removes resin species having a Mw of about 500 or less.

7. The method of claim 1 wherein the resin is treated with methylene chloride.

8. The method of claim 1 wherein the resin is treated with one or more of a halogenated solvent; a solvent having an ester; a lactate; a hydroxy-containing solvent; an ether; or an alkane.

9. The method of claim 1 wherein the resin is treated with one or more of chloroform, ethyl acetate, anisole, ethyl lactate, methyl lactate, a glycol, methanol, ethanol, hexane, or heptane.

10. The method of claim 1 wherein the resin is washed with the one or more organic solvents.

11. The method of claim 1 wherein the resin is extracted with the one or more organic solvents.

12. The method of claim 1 wherein the resin is Soxhlet extracted with the one or more organic solvents.

13. The method of claim 1 wherein the resin is a phenolic polymer.

14. The method of claim 1 wherein the resin comprises photoacid labile groups.

15. The method of claim 1 wherein the resin binder is a phenolic polymer with pendant inert blocking groups.

16. The method of claim 1 wherein the resin comprises phenolic and alkyl acrylate photoacid labile groups.

17. A photoresist composition comprising a photoactive component and a resin, the resin obtainable by treating a prepared resin with one or more organic solvents.

18. The photoresist composition of claim 17 wherein treatment with the organic solvent removes resin species having a Mw of about 2,000 or less.

19. The photoresist composition of claim 17 wherein treatment with the organic solvent removes resin species having a Mw of about 1,000 or less.

20. The photoresist composition of claim 17 wherein one or more organic solvents is methylene chloride.

21. The photoresist composition of claim 17 wherein the resin is washed with the one or more organic solvents.

22. The photoresist composition of claim 17 wherein the resin is extracted with one or more organic solvents.

23. A substrate having coated thereon a photoresist composition of claim 17.

24. A substrate of claim 23 wherein the photoresist composition is coated on a microelectronic wafer substrate.
